# EUROPEAN PATENT APPLICATION

(11) **EP 2 523 217 A1**
(43) Date of publication of application: **14.11.2012**
(21) Application number: 10840787.5
(22) Date of filing: 04.01.2010
(51) Int. Cl.: H01L 29/739, H01L 27/04, H01L 29/78, H01L 29/786

(54) **SEMICONDUCTOR DEVICE AND ELECTRIC POWER CONVERSION DEVICE USING SAME**

(71) Applicant: Hitachi, Ltd., Chiyoda-ku Tokyo 100-8280 (JP)
(72) Inventor: SHIRAISHI Masaki, Hitachi-shi Ibaraki 319-1292 (JP); MORI Mutsuhiro, Hitachi-shi Ibaraki 319-1292 (JP); SUZUKI Hiroshi, Hitachi-shi Ibaraki 319-1292 (JP); WATANABE So, Hitachi-shi Ibaraki 319-1292 (JP)
(74) Representative: Thesen, Michael
(86) International application number: PCT/JP2010/050003
(87) International publication number: WO 2011/080928

(57) **Abstract**

The trench IGBT is provided with a plurality of trench gates disposed in a manner so as to form wide and narrow of gaps; has a MOS structure that has a channel of a first conductivity type and that is between the trench gate pair that is disposed with a narrow gap therebetween; and is provided with a floating semiconductor layer of the first conductivity type and that is separated from the trench gates by interposing a portion of a third semiconductor layer of a second conductivity type between the trench gate pair that is disposed with a wide gap therebetween. Also, this floating semiconductor layer is disposed parallel to and at a position corresponding to an emitter electrode and a first semiconductor layer having the same electric potential, with a insulating film therebetween.

## Description

### TECHNICAL FIELD

The present invention relates to a structure of an Insulated Gate Bipolar Transistor (hereinafter, referred to as an "IGBT"), and a power conversion device using the IGBT.

### BACKGROUND ART

The IGBT is a switching element in which current flowing between a collector electrode and an emitter electrode is controlled by voltage applied to a gate electrode. Since the IGBT can control an electric power having range from several tens of watt to several hundreds of thousands of watt and has a switching frequency having wide range from several tens of Hz to several hundreds of Hz, the IGBT is widely used for low electric power equipments such as a domestic air conditioner and a microwave oven, etc. and high electric power equipments such as an inverter used for railroad and ironworks, etc.
The IGBT is required to be low-loss in order to increase efficiency of the electric power equipments, and is required to decrease a conduction loss and a switching loss. Techniques for decreasing the loss is disclosed in Patent Literatures 1-3.

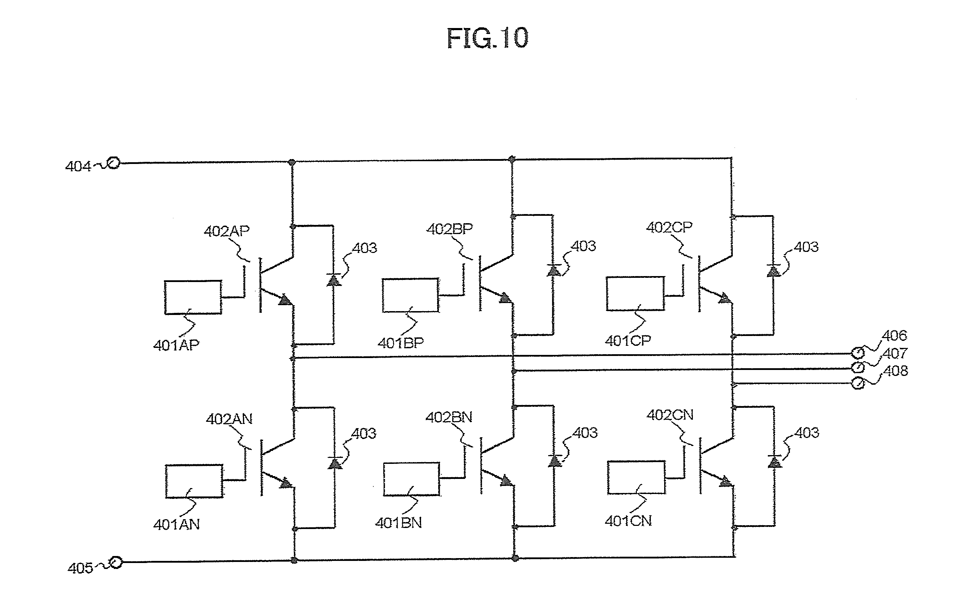

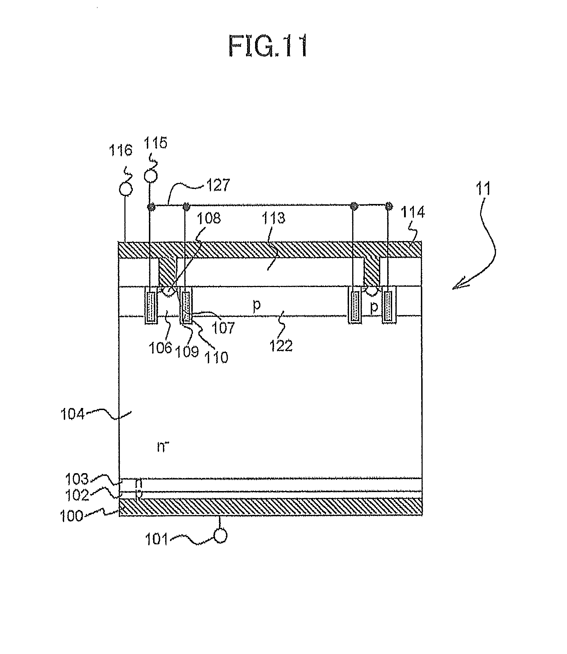

The Patent Literature 1 discloses a structure in which an arrangement pitch of a trench gate 109 shown in FIG. 11 is changed. The feature of the IGBT 11 shown in FIG. 11 is that a plurality of the trench gates 109 are provided and a floating-p layer 122 (not a channel layer 106) is formed at a portion where a gap between the trench gates is wide. According to the structure, a current flows through only a narrow portion (the channel layer 106) between the trench gates 109, an overcurrent can be suppressed at the time of short circuit, and a fracture tolerance of the device can be improved. Also, a part of a hole current flows into an emitter electrode 114 via the floating-p layer 122, a hole density in the vicinity of the emitter electrode is increased, electrons are attracted around the emitter electrode, and an ON-voltage of the IGBT can be lowered.
However, in the trench gate type IGBT 11 shown in FIG. 11, there arises a problem that when the IGBT is turned on, a current oscillation occurs and an overvoltage occurs across a diode 403 (FIG. 10) connected to an IGBT 402AP (FIG. 10) in parallel. This phenomenon is caused by the following reason. When the IGBT is turned on, holes flow into the floating-p layer 122 (FIG. 11), and a voltage of the floating-p layer 122 is increased. At this moment, a displacement current flows into the gate electrode 109 via a capacitance of the gate insulating film 110, and the gate voltage is pulled up. For this reason, a conductivity modulation is accelerated, and there arises a problem that the current oscillation occurs and the overvoltage occurs across the diode 403 (FIG. 10) connected to the IGBT 402AP (FIG. 10) in parallel.
Therefore, Patent Literatures 2 and 3 disclose techniques for suppressing the pull up of the gate voltage caused by the floating-p layer 122.

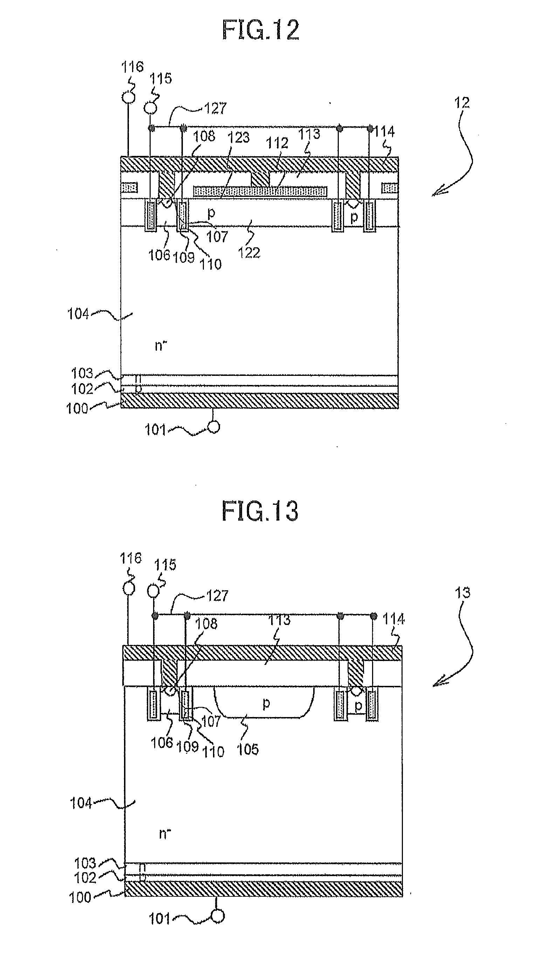

As shown in FIG. 12, in Patent Literature 2, a capacitance (a capacitor) comprising an insulating film 123 and a polycrystalline silicon 112 is provided on the floating-p layer 122, and is connected to the emitter electrode 114. That is, a structure in which the floating-p layer 122 is connected to the emitter electrode 114 via the capacitance is disclosed.
According to the disclosed method, when the hole current flows into the floating-p layer 122 at the time of turning-on, the capacitance on the floating-p layer 122 is charged with a part of the hole current, the pull up of the voltage of the floating-p layer 122 is suppressed, and the pull up of the gate voltage of the gate electrode 109 is suppressed.
Accordingly, in the IGBT 12 having a trench gate structure shown in FIG. 12, the thickness of the insulating film 123 is equal to or less than 150 nm (1500 angstrom) in order to increase the capacitance on the floating-p layer 122. However, especially at the time of turning-off, the voltage of the floating-p layer 122 is largely pulled up, and a strong electric field is applied to the insulating film 123. For this reason, the reliability of the insulating film 123 is lowered, and the insulating film 123 is destroyed in some cases.

Also, as shown in FIG. 13, in Patent Literature 3, a floating-p layer 105 is separated from a trench gate 109 (a gate electrode 109), and a n- drift layer 104 is provided therebetween.
According to the method, if the voltage of the floating-p layer 105 is pulled up at the time of turning-on, since the n⁻ drift layer 104 is provided between the floating-p layer 105 and the trench gate 109, the floating-p layer 105 indirectly affects the trench gate 109 via a resistor, and the pull up of the gate voltage of the gate electrode 109 can be suppressed.
However, in the trench gate type IGBT 13 shown in FIG. 13, since the floating-p layer 105 is separated from the trench gate 109, the electric field concentrates in a corner section of the trench gate 109 (including the gate insulating film 110), and a breakdown voltage of the IGBT is lowered.

### PRIOR ART REFERENCE

### Patent Literature

Patent Literature 1: JP 2000-307166 A
Patent Literature 2: JP 2009-194044 A
Patent Literature 3: JP 2008-207556 A

### SUMMARY OF THE INVENTION

### PROBLEMS TO BE SOLVED BY THE INVENTION

As described above, in the prior art IGBT, the current flows through only the narrow portion between the trench gates, and the floating-p layer is provided in order to suppress the overcurrent at the time of short circuit. However, a noise (a voltage displacement, the current oscillation) occurs via the floating-p layer. If the floating-p layer is separated from the trench gate in order to avoid the noise occurrence, the electric field concentrates in the corner section of the trench gate (including the gate insulating film), and the breakdown voltage of the IGBT is lowered.
The present invention is made in order to solve the above problem, and an object of the present is to provide an IGBT which is low-loss and low-noise (low voltage displacement, low current oscillation), has a high fracture tolerance, and suppresses an overcurrent at the time of short circuit.

### MEANS FOR SOLVING THE PROBLEM

In order to solve the above problem and to achieve the above object, the present invention is made as follows:
That is, a semiconductor device, comprising: a semiconductor substrate; a first semiconductor layer of a first conductivity type; a second semiconductor layer of a second conductivity type; a third semiconductor layer of the second conductivity type whose carrier density is lower than that of the second semiconductor layer; and a first insulating film, wherein the second semiconductor layer is disposed between the first semiconductor layer and the third semiconductor layer, and the third semiconductor layer is disposed between the second semiconductor layer and the first insulating film, the third semiconductor layer is provided with a plurality of insulated gates which is disposed so that gaps therebetween are at least wide and narrow, a second insulating film is provided around the insulated gate, the fourth semiconductor layer of first conductivity type and the fifth semiconductor layer of second conductivity type are provided between the insulated gates which are disposed with the narrow gap are provided so that one side of the fourth semiconductor layer is adjacent to the third semiconductor layer and other side of the fourth semiconductor layer is adjacent to the fifth semiconductor layer, and a sixth semiconductor layer of first conductivity type is provided between the insulated gates which are disposed with the wide gap so as to be separated from the insulated gate via a part of the third semiconductor layer and to be adjacent to the first insulating film, and further comprising: a first conducting layer which is provided corresponding to and in parallel with the sixth semiconductor layer, and is electrically insulated from the sixth semiconductor layer by the first insulating film; a first electrode which is electrically connected to the fourth semiconductor layer, the fifth semiconductor layer, and the first conducting layer; a second electrode which is electrically connected to one side of the first semiconductor layer opposite to the second semiconductor layer; and a third electrode which is electrically connected to the insulated gate, is provided.

According to the above structure, the overcurrent is suppressed in the floating-p layer, the noise (the voltage displacement, the current oscillation) via the floating-p layer is decreased, the electric field is prevented from concentrating in the corner section of the trench gate, and the breakdown voltage of the device is improved.

### EFFECT OF THE INVENTION

According to the present invention, an IGBT which is low-loss and low-noise (low voltage displacement, low current oscillation), has a high fracture tolerance, and suppresses an overcurrent at the time of short circuit, can be provided.

### BRIEF DESCRIPTION OF THE DRAWINGS

FIG. 1 is a sectional view showing a structure of a trench gate type IGBT (a semiconductor device) according to a first embodiment of the present invention;
FIG. 2 is a sectional view showing a structure of a trench gate type IGBT (a semiconductor device) according to a second embodiment of the present invention;
FIG. 3 is a sectional view showing a structure of a trench gate type IGBT (a semiconductor device) according to a third embodiment of the present invention;
FIG. 4 is a plan view showing the structure of the trench gate type IGBT (the semiconductor device) according to the third embodiment of the present invention;
FIG. 5 is a sectional view showing the structure of the trench gate type IGBT (the semiconductor device) according to the third embodiment of the present invention;
FIG. 6 is the sectional view showing the structure of the trench gate type IGBT (the semiconductor device) according to the third embodiment of the present invention;
FIG. 7 is a sectional view showing a structure of a trench gate type IGBT (a semiconductor device) according to a fourth embodiment of the present invention;
FIG. 8 is a sectional view showing a structure of a trench gate type IGBT (a semiconductor device) according to a fifth embodiment of the present invention;
FIG. 9 is a sectional view showing a structure of a lateral trench gate type IGBT (a semiconductor device) according to a sixth embodiment of the present invention;
FIG. 10 is a circuit diagram of an embodiment of a power conversion device according to the present invention;
FIG. 11 is a sectional view showing a structure of a conventional trench gate type IGBT;
FIG. 12 is a sectional view showing a structure of s conventional trench gate type IGBT; and
FIG. 13 is a sectional view showing a structure of a conventional trench gate type IGBT.

### EMBODIMENTS FOR CARRYING OUT THE INVENTION

Hereinafter, embodiments of the present invention will be explained.

### (First Embodiment of Semiconductor Device)

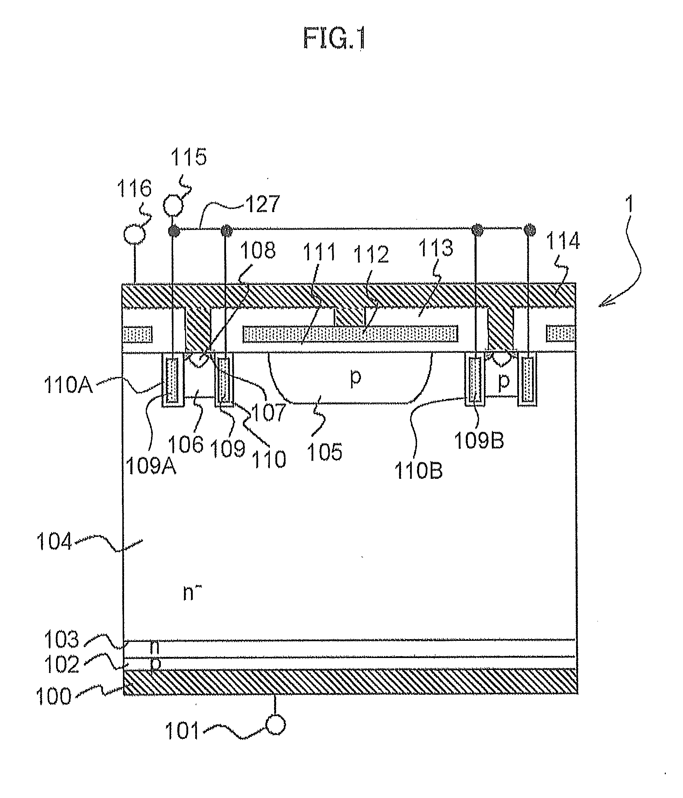

FIG. 1 shows a structure of a trench gate type IGBT 1 as a semiconductor device according to a first embodiment of the present invention. FIG. 1 shows an IGBT based on a silicon substrate (a semiconductor substrate). The silicon substrate is a thin wafer, and a device structure for constituting the IGBT is formed respectively on a front side and a back side (a pair of surfaces).
In FIG. 1, a p-collector layer (a first semiconductor layer) 102, an n-buffer layer (a second semiconductor layer) 103, an n⁻ drift layer (a third semiconductor layer) 104, a p-channel layer (a fourth semiconductor layer) 106, a gate electrode 109, and an n-emitter layer (a fifth semiconductor layer) 107 serve as basic components of the IGBT 1. In addition, since the gate electrode 109 is provided in a deep well bored as a trench structure, the gate electrode 109 may be referred to as a "trench gate 109".
As described above, the p-collector layer 102 and the n-buffer layer 103 are formed in a region in the proximity of the back side of the silicon substrate. Also, the p-channel layer 106, the gate electrode 109, and the n-emitter layer 107 are formed in a region in the proximity of the front side of the silicon substrate. Also, the n⁻ drift layer 104 is mainly formed between the back side and the front side of the silicon substrate. In addition, the front side and the back side are relative to each other, and are merely referred to as above for convenience.

In FIG. 1, the IGBT 1 is turned on and off by supplying a positive source voltage to the p-collector layer 102 and a voltage to the gate electrode 109. Further, a current amount flowing through the IGBT is controlled on condition that the IGBT is turned on. When a negative voltage is supplied to the gate electrode 109, the IGBT behaves as a Metal Oxide Semiconductor Field Effect Transistor (hereinafter, referred to as a "MOSFET"), the p-channel layer 106 attracts more holes (positive holes), a p-n diode having a reverse characteristics to the supplied voltage is formed between the p-channel layer 106 and the n- drift layer 104, a current is not allowed to flow, and the IGBT 1 is turned off.
Also, when a positive voltage is supplied to the gate electrode 109, the IGBT behaves as the MOSFET, electrons are induced in the p-channel layer 106, and a channel region inverted to n-type is formed in the p-channel layer 106. As a result, the n-emitter layer 107, the channel region (the p-channel layer) 106 inverted to n-type, the n⁻ drift layer 104, and the n-buffer layer 103 (i.e., n-type semiconductor elements) are electrically continuous, a forward p-n diode is formed between the n-type semiconductor elements and the p-collector layer 102, a current flows, and the IGBT is turned on. In addition, the current amount flowing through the IGBT 1 is changed by changing the positive voltage supplied to the gate electrode 109.

A basic structure of the IGBT 1 has been described above. In order to use the IGBT 1 as a practical device, a collector electrode (a second electrode) 100 and a collector terminal 101 are provided so that the p-collector layer 102 is connected to a power source. Also, an emitter electrode (a first electrode) 114 and an emitter terminal 116 are provided so that the n-emitter layer 107 is connected to the power source. Also, a gate wiring electrode (a third electrode) 127 and a gate terminal 115 are provided so that voltage is supplied to the gate electrode 109. In addition, the gate wiring electrode 127 is indicated as only a graphical symbol in FIG. 1 since a real structure can not be drawn in the sectional view. Actually, the gate wiring electrode 127 is made with a metal wiring material, etc. in a manufacturing process of the semiconductor device (IGBT 1).
Also, the gate insulating film 110 is provided around the gate electrode 109 so that the gate electrode 109 is electrically insulated from the n⁻ drift layer 104 and the p-channel layer 106. Also, a p-contact layer 108 whose impurity concentration is higher than that of the p-channel layer 106 is provided so that the voltage of the emitter electrode 114 is applied to the p-channel layer 106 via the p-contact layer 108. In addition, the p-contact layer 108 is not an essential component. However, it is better to provide the p-contact layer 108 since a contact between the emitter electrode 114 and the p-channel layer 106 becomes good state and the characteristics of the IGBT 1 can be improved.

For example, in FIG. 1, a gate electrode 109A and a gate electrode 109B may be provided other than the gate electrode 109. The gate electrode 109A is provided at a position which is symmetrical to the gate electrode 109 with respect to the p-channel layer 106. Also, the gate electrode 109B is provided at a position which is symmetrical to the gate electrode 109 with respect to the floating-p layer 105. The gap between the gate electrode 109 and the gate electrode 109A differs from that between the gate electrode 109 and the gate electrode 109B. The gap between the gate electrode 109 and the gate electrode 109A is relatively narrow, and the distance between the gate electrode 109 and the gate electrode 109B is relatively wide.

A floating-p layer (a sixth semiconductor layer) 105 is provided between the gate electrode 109 and the gate electrode 109B. The floating-p layer 105 is adjacent to the n⁻ drift layer 104 in horizontal and vertical directions. An insulating film (a first insulating film) 111 is provided on the floating-p layer 105, and the polycrystalline silicon (a first conducting layer) 112 is provided on the insulating film 111. Also, the polycrystalline silicon 112 is connected to the emitter electrode 114. Also, the insulating film 113 is provided so that the emitter electrode 114 and the polycrystalline silicon 112 are electrically insulated from the gate terminal 115 and the n⁻ drift layer 104. In addition, the polycrystalline silicon 112 (the first semiconductor) is provided corresponding to and in parallel with the floating-p layer 105, and is electrically insulated from the floating-p layer 105 by the insulating film 111.
The floating-p layer 105 is provided between the gate electrode 109 and the gate electrode 109B, and prevents a current, which can not be controlled by the gate electrode 109 and the gate electrode 109B, from flowing through the n- drift layer 104 provided between the gate electrode 109 and the gate electrode 109B. In addition, a device destruction is caused by a high concentration of current at a part of the device or a large current flowing through the device (a thermal breakdown).

The features of the structure of this embodiment are that a capacitance (a capacitor) comprising the insulating film 111 (more than 300 nm), which is thicker than the gate insulating film 110 (50 nm - 100 nm), and the polycrystalline silicon 112 is provided on the floating-p layer 105 so as to be connected to the emitter electrode 114, and that the floating-p layer 105 is provided separate from the trench gates 109 and 109B.
Since the IGBT 1 is provided with the thick insulating film 111, the electric field applied to the insulating film 111 can be reduced and decline in reliability and destruction of the insulating film 111 can be suppressed if the voltage of the floating-p layer 105 is pulled up at the time of turning off.

Also, by forming the thick insulating film 111, the capacitance comprising the polycrystalline silicon 112 and the insulating film 111 is downsized, and a suppression effect on the pull up of the voltage of the floating-p layer 105 is declined. However, by separating the floating-p layer 105 from the trench gates 109 and 109B, the pull up of the gate voltage can be suppressed. That is, the low-noise IGBT can be provided.
In addition, since the insulating film 111 is made in an oxide film forming process other than that in which the gate insulating film 110 of the trench gates 109 and 109B (in the prior art, they are made in the same forming process), the insulating film 111 which is thicker than the gate insulating film 110 of the trench gates 109 and 109B can be formed. However, since the thick insulating film 111 and an interlayer film which is used in a peripheral structure, etc. can be formed at the same time, an additional manufacturing process is not required. Accordingly, the chop manufacturing cost is not increased.

Further, since an end portion of the polycrystalline silicon 112 connected to the emitter electrode 114 extends to an upper portion of the n- drift layer 104 between the floating-p layer 105 and the trench gates 109 and 109B, a depletion region in the n⁻ drift layer 104 under the polycrystalline silicon 112 increases at the time when the IGBT 1 is turned off, the electric field concentration in the corner section of the trench gates 109 and 109B (including the gate insulating film 110) is eased, and the breakdown voltage is improved.
In this embodiment, by providing the thick insulating film 111 on the floating-p layer 105 and by extending the polycrystalline silicon 112 to the upper portion of the n⁻ drift layer 104, the low-noise and low-loss IGBT 1 can be provided while keeping the reliability and the breakdown voltage of the insulating film.

### (Second Embodiment of Semiconductor Device)

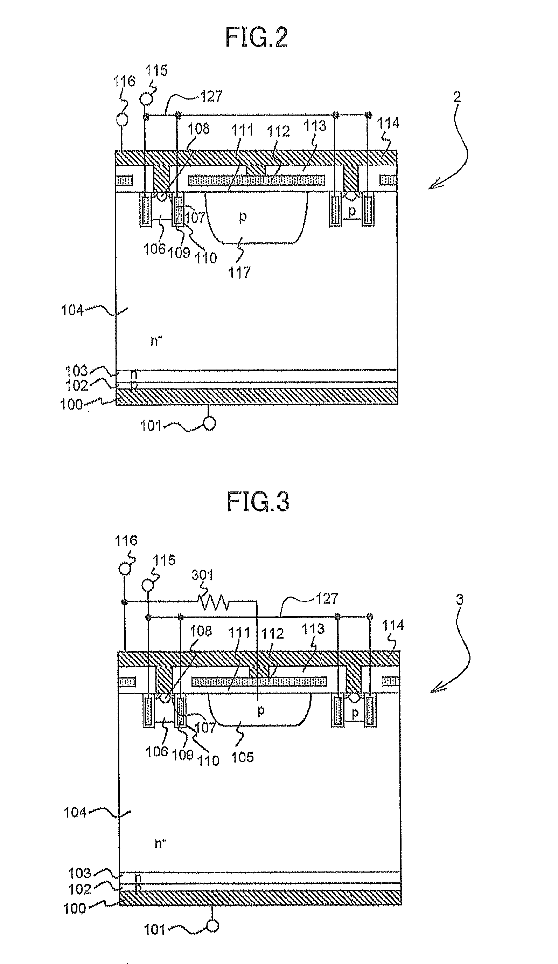

FIG. 2 is a sectional view showing a structure of a trench gate type IGBT 2 as a semiconductor device according to a second embodiment of the present invention.
In FIG. 2, the p-collector layer 102, the n-buffer layer 103, the n⁻ drift layer 104, the p-channel layer 106, the gate electrode 109, and the n-emitter layer 107 are provided as basic components of the IGBT 2.
Also, in order to use the IGBT 2 as a practical device, the collector electrode 100, the collector terminal 101, the emitter electrode 114, the emitter terminal 116, the gate wiring electrode 127, the gate terminal 115, the gate insulating film 110, the p-contact layer 108, and the insulating film 113 are provided.
Also, in order to keep the IGBT low-noise and breakdown voltage, the floating-p layer 105, the insulating film 111, and the polycrystalline silicon 112 are provided.
Since these components are the same as those of the structure shown in FIG. 1, the explanation will be omitted.

The feature of the structure of this embodiment is that a floating-p layer 117 is formed to be deeper than the p-channel layer 106 and the trench gate 109. Since a depletion layer expands from the deep floating-p layer 117 at the time when the IGBT is turned off, the electric field is the corner section of the trench gate 109 (including the gate insulating film 110) is eased, and the breakdown voltage can be improved. For this reason, the floating-p layer 117 can be provided at a position further from the trench gate 109, and the low-noise IGBT can be provided.
In addition, since the deep floating-p layer 117 can be formed in a process for manufacturing a deep well layer used in a peripheral region, an additional manufacturing process is not required, and the manufacturing cost is not increased.

### (Third Embodiment of Semiconductor Device)

FIG. 3 is a sectional view showing a structure of a trench gate type IGBT 3 as a semiconductor device according to a third embodiment of the present invention.
In FIG. 3, the p-collector layer 102, the n-buffer layer 103, the n⁻ drift layer 104, the p-channel layer 106, the gate electrode 109, and the n-emitter layer 107 are provided as basic components of the IGBT 3.
Also, in order to use the IGBT 3 as a practical device, the collector electrode 100, the collector terminal 101, the emitter electrode 114, the emitter terminal 116, the gate wiring electrode 127, the gate terminal 115, the gate insulating film 110, the p-contact layer 108, and the insulating film 113 are provided.
Also, in order to keep the IGBT low-noise and breakdown voltage, the floating-p layer 105, the insulating film 111, and the polycrystalline silicon 112 are provided.
Since these components are the same as those of the structure shown in FIG. 1, the explanation will be omitted.

In FIG. 3, the structure shown in FIG. 1 further includes a resistor 301.
The feature of the structure of this embodiment is that the floating-p layer 105 is connected to the emitter terminal 116 via the resistor 301.
By connecting the floating-p layer 105 to the emitter terminal 116, the pull up of the voltage of the floating-p layer 105 is suppressed, and a current oscillation and an overvoltage across a diode connected to the IGBT 3 in parallel (e.g., a diode 403 connected to an IGBT 402AP in FIG. 10) at the time when the IGBT 3 is turned can be suppressed.
If a resistor value of the resistor 301 is too low, holes flow into the floating-p layer 105 and flow through the emitter terminal 116, and a suppression effect on the ON-voltage by providing the floating-p layer 105 is declined. Accordingly, the resistor value of the resistor 301 is preferably a certain level of value (e.g., more than 100 Ω). Also, the resistor 301 can be made of a diffused resistor of the floating-p layer 105 or a resistor means embedded in a semiconductor device (IGBT 3) such as a polycrystalline silicon, etc. Further, in some cases, the resistor 301 may be an external resistor.

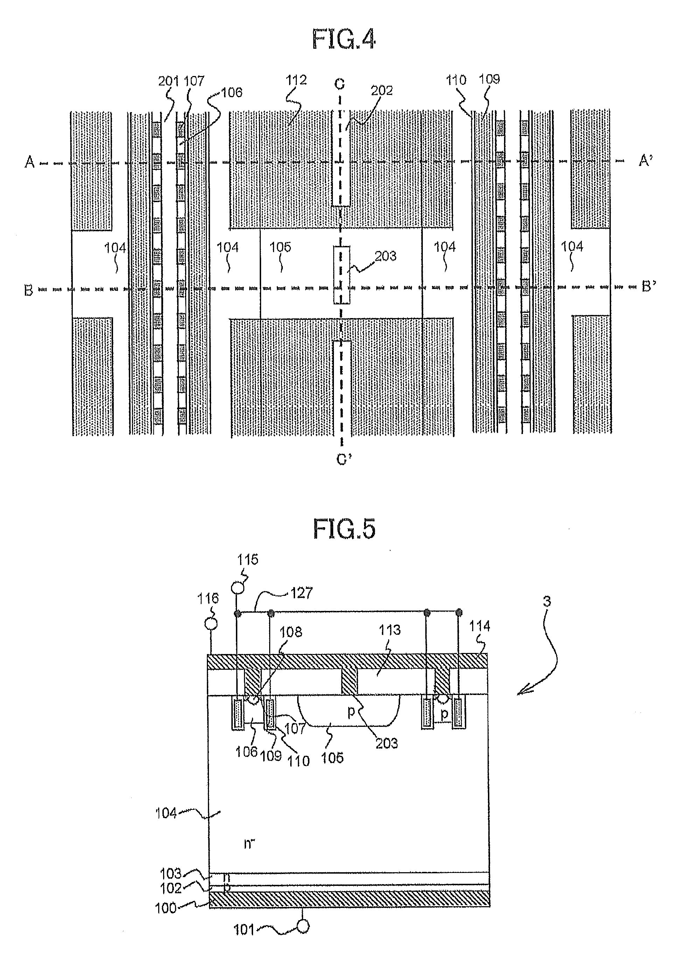

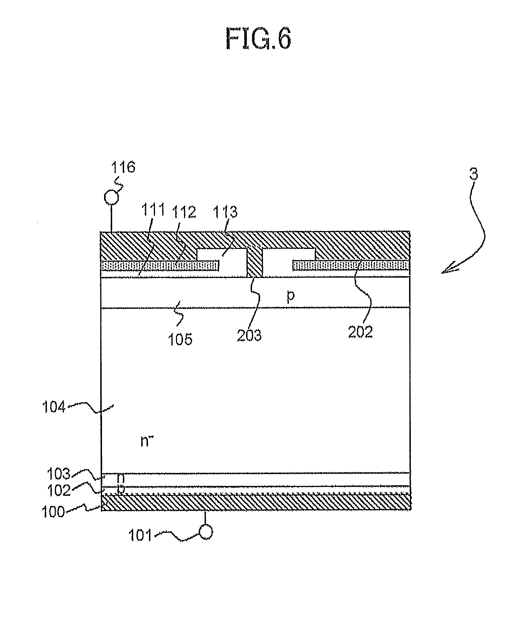

FIG. 4 is a plan view showing the resistor 301 (FIG. 3) made of the diffused resistor which is originally included in the floating-p layer 105 (FIGS. 3 and 4) in a semiconductor as an example of the third embodiment.
Further, FIG. 5 shows a sectional structure along the line B-B' in FIG. 4, and FIG. 6 shows a sectional structure along the lien C-C' in FIG. 4. Also, FIG. 3 shows a sectional structure along the line A-A' in FIG. 4.
In FIG. 4, the n⁻ drift layer 104 the floating-p layer 105, the p-channel layer 106, the n-emitter layer 107, the gate electrode 109, the gate insulating film 110, and the polycrystalline silicon 112 correspond to sectional views shown in FIGS. 1 and 3.

The resistor value of the resistor 301 (FIG. 3) is changed depending on a shape of the floating-p layer 105 (FIGS. 3 and 4). The resistor value is changed depending on a length in the vertical direction (a direction parallel to the line C-C') and a width in the horizontal direction (a direction parallel to the line B-B') of the floating-p layer 105 in FIG. 4.
Also, as shown in FIG. 4, by providing a contact 203, the floating-p layer 105 is connected to the emitter electrode. By providing the plurality of contacts 203 (FIGS. 4 and 5) intermittently and changing gaps between the contacts 203, a substantial resistor value of the resistor 301 can be changed easily.

### (Fourth Embodiment of Semiconductor Device)

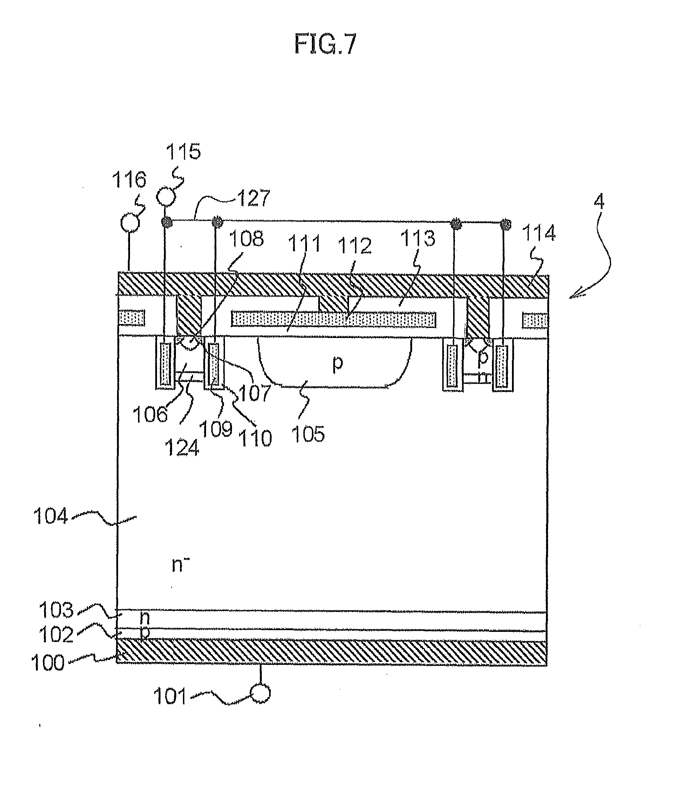

FIG. 7 is a sectional view showing a structure of a trench gate type IGBT 4 as a semiconductor device according to a fourth embodiment of the present invention.
In FIG. 7, the p-collector layer 102, the n-buffer layer 103, the n⁻ drift layer 104, the p-channel layer 106, the gate electrode 109, and the n-emitter layer 107 are provided as basic components of the IGBT 4.
Also, in order to use the IGBT 4 as a practical device, the collector electrode 100, the collector terminal 101, the emitter electrode 114, the emitter terminal 116, the gate wiring electrode 127, the gate terminal 115, the gate insulating film 110, the p-contact layer 108, and the insulating film 113 are provided.
Also, in order to keep the IGBT low-noise and breakdown voltage, the floating-p layer 105, the insulating film 111, and the polycrystalline silicon 112 are provided.
Since these components are the same as those of the structure shown in FIG. 1, the explanation will be omitted.

The feature of the structure of this embodiment is that an n-electron barrier layer (a seventh semiconductor layer) 124 which is comprised of an n-type diffusion layer is formed under the p-channel layer 106 (in the direction toward a middle between a front side and a back side of a wafer of a silicon substrate).
Since the n-electron barrier layer 124 becomes a barrier for holes which flow into the n-emitter layer 107 (the emitter electrode 114), a hole density in the vicinity of the n-emitter layer 107 is increased, electrons are attracted around the n-emitter layer 107, and an ON-voltage of the IGBT 4 can be further lowered.

### (Fifth Embodiment of Semiconductor Device)

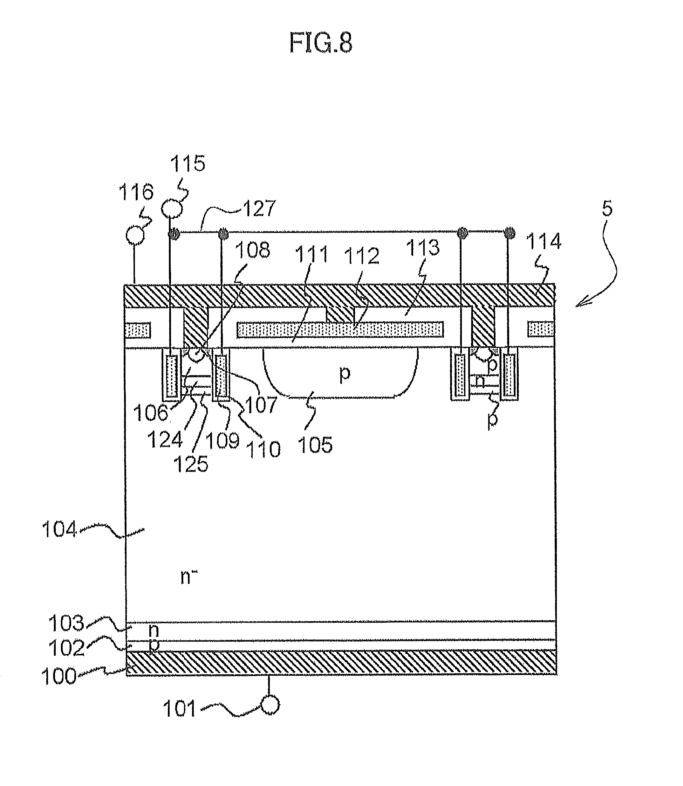

FIG. 8 is a sectional view showing a structure of a trench gate type IGBT 5 as a semiconductor device according to a fifth embodiment of the present invention.
In FIG. 8, the p-collector layer 102, the n-buffer layer 103, the n⁻ drift layer 104, the p-channel layer 106, the gate electrode 109, and the n-emitter layer 107 are provided as basic components of the IGBT 5.
Also, in order to use the IGBT 5 as a practical device, the collector electrode 100, the collector terminal 101, the emitter electrode 114, the emitter terminal 116, the gate wiring electrode 127, the gate terminal 115, the gate insulating film 110, the p-contact layer 108, and the insulating film 113 are provided.
Also, in order to keep the IGBT low-noise and breakdown voltage, the floating-p layer 105, the insulating film 111, and the polycrystalline silicon 112 are provided.
Also, in order to lower the ON-voltage, the n-electron barrier layer 124 is provided.
Since these components are the same as those of the structure shown in FIG. 7, the explanation will be omitted.

The feature of the structure of the fifth embodiment of the present invention is that a p layer (a eighth semiconductor layer) 125 is further formed under the n-electron barrier layer 124 (in the direction toward a middle between a front side and a back side of a wafer of silicon substrate). In the structure of the fourth embodiment shown in FIG. 7, the higher the carrier density of the n-electron barrier layer 124, the higher the barrier to the holes and the suppression effect on the ON-voltage of the IGBT 4. However, the electric field applied to the n-electron barrier layer 124 at the time when the IGBT 4 is turned off is increased, and the breakdown voltage is lowered.
By adding the p layer 125 shown in FIG. 8 according to the fifth embodiment of the present invention, the electric field applied to the n-electron barrier layer 124 is eased. Since the breakdown voltage can be kept if the carrier density of the n-electron barrier layer 124 is made to be higher, the ON-voltage of the IGBT 5 can be lowered.
In addition, the ON-voltage of the IGBT 5 is determined by a bipolar transistor, namely, by a current, the ON-voltage of the IGBT 5 is not increased by adding the p layer 125 to the channel (the p-channel layer 106) of the MOSFET.

### (Sixth Embodiment of Semiconductor Device)

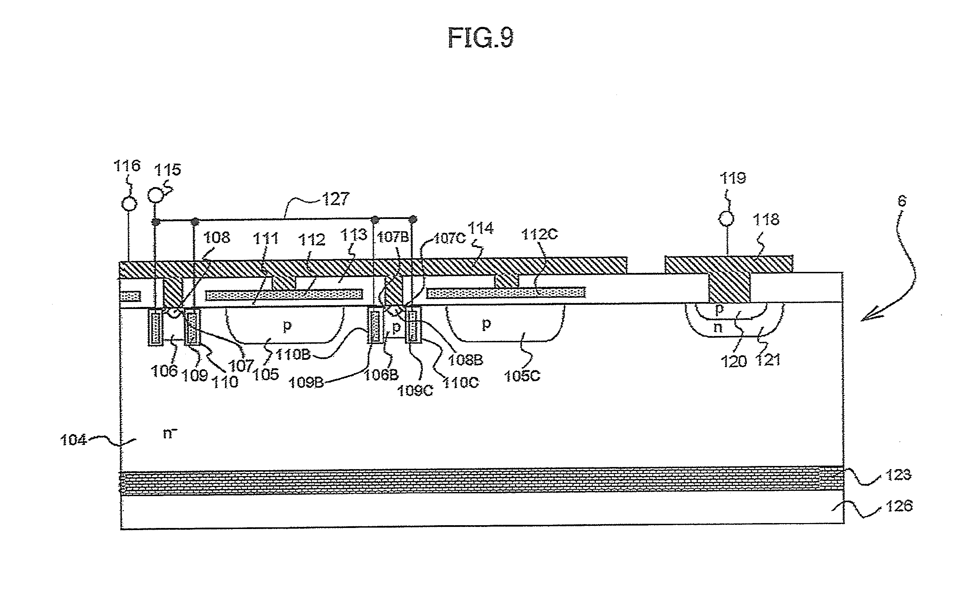

FIG. 9 is a sectional view showing a structure of a trench gate type IGBT 6 as a semiconductor device according to a sixth embodiment of the present invention.
Unlike the first embodiment shown in FIG. 1, in FIG. 9, a p-collector layer 120 and an n-buffer layer 121 of the IGBT 6 are formed on the same front side of the silicon substrate as that on which the n-emitter layers 107 (107B, 107C) are formed. The feature of the structure of this embodiment is that a vertical structure of the first embodiment is reconstructed to be a lateral structure.
The p-collector layer 120, the n-buffer layer 121, the n⁻ drift layer 104, the p-channel layer 106 (106B), the gate electrode 109 (109B, 109C), and the n-emitter layer 107 (107B, 107C) are provided as basic components of the IGBT 6.

The trench gate type IGBT 6 is turned on and off by supplying a positive source voltage to the p-collector layer 102 and a voltage to the gate electrode 109 (109B, 109C). When a negative voltage is supplied to the gate electrode 109 (109B, 109C), the p-channel layer 106 (106B) attracts more holes (positive holes), a p-n diode having a reverse characteristics to the supplied voltage is formed between the p-channel layer 106 (106B) and the n- drift layer 104, a current is not allowed to flow, and the IGBT 6 is turned off. Also, when a positive voltage is supplied to the gate electrode 109 (109B, 109C), electrons are induced in the p-channel layer 106 (106B), and a channel region inverted to n-type is formed in the p-channel layer 106 (106B). As a result, the n-emitter layer 107 (107B, 107C), the channel region (the p-channel layer) 106 (106B) inverted to n-type, the n⁻ drift layer 104, and the n-buffer layer 121 (i.e., n-type semiconductor elements) are electrically continuous, a forward p-n diode is formed between the n-type semiconductor elements and the p-collector layer 120, a current flows, and the IGBT is turned on.

In order to use the IGBT 6 as a practical device, the collector electrode 118 and a collector terminal 119 is provided so that the p-collector layer 120 is connected to a power source. Also, the emitter electrode 114 and the emitter terminal 116 are provided so that the n-emitter layer 107 (107B, 107C) is connected to the power source. Also, the gate wiring electrode 127 and the gate terminal 115 are provided so that voltage is supplied to the gate electrode 109 (109B, 109C). Also, the gate insulating film 110 (110B, 110C) is provided around the gate electrode 109 (109B, 109C) so that the gate electrode 109 (109B, 109C) is electrically insulated from the n- drift layer 104 and the p-channel layer 106 (106B). Also, the p-contact layer 108 (108B) whose impurity concentration is higher than that of the p-channel layer 106 (106B) is provided so that the voltage of the emitter electrode 114 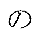 is applied to the p-channel layer 106 (106B) via the p-contact layer 108 (108B).

As described above, the floating-p layer 105 is provided between the gate electrode 109 and the gate electrode 109B. The floating-p layer 105C is adjacent to the gate electrode 109C in horizontal direction. The floating-p layer 105 (105C) is adjacent to the n⁻ drift layer 104 in horizontal and vertical directions. An insulating film 111 is provided on the floating-p layer 105 (105C), the polycrystalline silicon 112 (112C) is provided on the insulating film 111, and the polycrystalline silicon 112 (112C) is connected to the emitter electrode 114. Also, the insulating film 113 is provided so that the emitter electrode 114 and the polycrystalline silicon 112 (112C) are electrically insulated from the gate terminal 115 and the n⁻ drift layer 104.
Also, an insulating layer 123 which is comprised of an oxide film is adjacent to silicon substrate 126 in the vertical direction. The n⁻ drift layer 104 is insulated from the silicon substrate 126 by the insulating layer 123. Also, the silicon substrate 126 supports the semiconductor device 6 as a supporting substrate.

As described above, the structure of the IGBT shown in FIG. 9 differs from that shown in FIG. 1. The feature of the structure of the IGBT 6 shown in FIG. 9 is that the vertical structure of the IGBT 1 shown in FIG. 1 is reconstructed to be the lateral structure. Although the lateral structure (IGBT 6) differs from the vertical structure (IGBT 1), basic components thereof are the same. Accordingly, the lateral structure can achieve the same low-loss and low-noise effect as that of the first embodiment shown in FIG. 1. Also, in FIG. 9, a Silicon On Insulator (SOI) substrate which is made by forming the insulating layer 123 on the silicon substrate 126 is used.

### (Embodiment of Power Conversion Device)

FIG. 10 is a circuit diagram of a power conversion device according to an embodiment of the present invention.
FIG. 10 shows a circuit diagram of a (power conversion) inverter for converting a direct-current power to a three-phase alternating-current power.
A direct-current voltage (a direct-current power) is applied between an input terminal 404 and an input terminal 405. A collector of the IGBT 402AP is connected to a terminal 404, an emitter is connected to a collector of the IGBT 402AN, and an emitter of the IGBT 402AN is connected to the input terminal 405. Diodes 403 are connected in parallel between the emitters and the collectors of the IGBT 402AP and the IGBT 402AN respectively. Gates of the IGBT 402AP and the IGBT 402AN are driven and controlled by the gate driving circuit 401 AP and the gate driving circuit 401AN respectively. A junction point of the emitter of the IGBT 402AP and the collector of the IGBT 402AN is connected to the output terminal 406.
The collector of the IGBT 402BP is connected to the terminal 404, the emitter thereof is connected to the collector of the IGBT 402BN, and the emitter of the IGBT 402BN is connected to the input terminal 405. The diodes 403 are connected in parallel between the emitters and the collectors of the IGBT 402BP and the IGBT 402BN respectively. The gates of the IGBT 402BP and the IGBT 402BN are driven and controlled by the gate driving circuit 401BP and the gate driving circuit 401BN respectively. A junction point of the emitter of the IGBT 402BP and the collector of the IGBT 402BN is connected to the output terminal 407.
The collector of the IGBT 402CP is connected to the terminal 404, the emitter thereof is connected to the collector of the IGBT 402CN, and the emitter of the IGBT 402CN is connected to the input terminal 405. The diodes 403 are connected in parallel between the emitters and the collectors of the IGBT 402CP and the IGBT 402CN respectively. The gates of the IGBT 402CP and the IGBT 402CN are driven and controlled by the gate driving circuit 401CP and the gate driving circuit 401CN respectively. A junction point of the emitter of the IGBT 402CP and the collector of the IGBT 402CN is connected to the output terminal 408.

The IGBT 402AP and the IGBT 402AN are driven and controlled by the gate driving circuit 401 AP and the gate driving circuit 401AN respectively, and a positive or negative direct-current voltage, or an open circuit voltage is output from the output terminal 406. The IGBT 402BP and the IGBT 402BN are driven and controlled by the gate driving circuit 401BP and the gate driving circuit 401BN respectively, and a positive or negative direct-current voltage, or an open circuit voltage is output from the output terminal 407. The IGBT 402AP and the IGBT 402CN are driven and controlled by the gate driving circuit 401CP and the gate driving circuit 401CN respectively, and a positive or negative direct-current voltage, or an open circuit voltage is output from the output terminal 408.
Voltages suitable for driving a three-phase alternating current load (mainly, an electric motor) are output from the output terminals 406, 407, 408 in combination. These voltages are controlled by the gate driving circuits 401 AP, 401AN, 401BP, 401BN, 401CP, and 401CN in cooperation. By controlling these voltages, output voltages (output powers) for driving the three-phase alternating current load (mainly, an electric motor) at any frequency and voltage can be output from the output terminals 406, 407, and 408 in combination.
The feature of the power conversion device according the embodiment of the present invention shown in FIG. 10 is that the inverter circuit is provided with any one of IGBTs according to the first to sixth embodiments of the present invention. By applying the IGBT according to this embodiment to a power conversion device, a low-loss and high reliability power conversion device can be achieved.

### (Other Embodiment)

In addition, although the inverter circuit has been explained as an embodiment of the power conversion device of the present invention, the same low-loss and high-reliable effect as that of the above embodiments can be achieved by applying the IGBT according to the embodiment of the present invention to power conversion devices such as a converter and a chopper, etc.

Also, as described above, the n-emitter layers 107, 107B, and 107C are made of an n-type semiconductor layer, the p-collector layers 102 and 120 are made of a p-type semiconductor layer, the n-buffer layer 103 and 121 are made of an n-type semiconductor layer, and the n⁻ drift layer 104 is made of an n⁻-type semiconductor layer in the bipolar transistor, and the p-channel layer 106 is made of a p⁻-type semiconductor layer in the MOSFET. However, these p-type and n-type polarities can be exchangeable each other. Also, voltage polarities of the emitter electrode, the collector electrode, and the gate wiring electrode can be reversible. In this way, an IGBT having reverse voltage characteristics can be obtained.

Also, in the trench gate type IGBT 4 having the vertical structure shown in FIG. 7, a Silicon On Insulator (SOI) substrate which is made by forming the insulating layer 123 on the silicon substrate 126 is used. However, a p⁺ substrate may be sued.

Also, in the trench gate type IGBT 1 having the vertical structure shown in FIG. 1, the IGBT is made based on the silicon substrate 126. However, the silicon substrate is not always necessary. A semiconductor substrate which is made other than silicon can be used depending on a manufacturing process condition.

As described above, according to the present invention, an IGBT which is low-loss and low-noise (low voltage displacement, low current oscillation), has a high fracture tolerance, and suppresses an overcurrent at the time of short circuit can be provided by providing a capacitance comprising a thin insulating film and a polycrystalline silicon on a floating-p layer, and a floating-p layer separate from a trench gate in a trench gate type IGBT.

### INDUSTRIAL APPLICABILITY

The uses of the IGBT is expanding as a switching element which supports high voltage, high power, and high frequency. The IGBT (the semiconductor device) according to the present invention improves its noise characteristics and breakdown voltage, and achieves low-loss characteristics. For this reason, the IGBT of the present invention of a power conversion device having the IGBT may widely used for a domestic low electric power equipment, or a high electric power equipment for a railroad or a factory.

### EXPLANATION OF REFERENCES

1, 2, 3, 4, 5, 6, 11, 12, 13: IGBT, semiconductor device
100: collector electrode, second electrode
101: collector terminal
102, 120: p-collector layer, first semiconductor layer
103, 121: n-buffer layer, second semiconductor layer
104: n⁻ drift layer, third semiconductor layer
105, 105C, 117, 122: floating-p layer, sixth semiconductor layer
106: p-channel layer, fourth semiconductor layer
107, 107B, 107C: n-emitter layer, fifth semiconductor layer
108, 108B p contact layer
109, 109A, 109B, 109C: gate electrode, trench gate, insulated gate
110, 110A, 110B: gate insulating film , 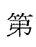 2 insulating film
111, 123: insulating film, first insulating film
112, 112C: polycrystalline silicon, first conducting layer
113: insulating film
114, 118: emitter electrode, first electrode
115: gate terminal
116, 119: emitter terminal
124: n-electron barrier layer, seventh semiconductor layer
125: p layer, eighth semiconductor layer
126: silicon substrate, semiconductor substrate
127: gate wiring electrode, third electrode
201, 202, 203: contact
301: resistor, resistor means
401AP, 401AN, 401BP, 401BN, 401CP, 401CN: gate driving circuit
402AP, 402AN, 402BP, 402BN, 402CP, 402CN: IGBT, semiconductor device
403: diode
404, 405: input terminal
406, 407, 408: output terminal

## Claims

1. A semiconductor device, comprising:
a semiconductor substrate;
a first semiconductor layer of a first conductivity type;
a second semiconductor layer of a second conductivity type;
a third semiconductor layer of the second conductivity type whose carrier density is lower than that of the second semiconductor layer; and
a first insulating film, wherein
the second semiconductor layer is disposed between the first semiconductor layer and the third semiconductor layer, and the third semiconductor layer is disposed between the second semiconductor layer and the first insulating film,
the third semiconductor layer is provided with a plurality of insulated gates which is disposed so that gaps therebetween are at least wide and narrow,
a second insulating film is provided around the insulated gate,
the fourth semiconductor layer of first conductivity type and the fifth semiconductor layer of second conductivity type are provided between the insulated gates which are disposed with the narrow gap are provided so that one side of the fourth semiconductor layer is adjacent to the third semiconductor layer and other side of the fourth semiconductor layer is adjacent to the fifth semiconductor layer, and
a sixth semiconductor layer of first conductivity type is provided between the insulated gates which are disposed with the wide gap so as to be separated from the insulated gate via a part of the third semiconductor layer and to be adjacent to the first insulating film, and further comprising:
a first conducting layer which is provided corresponding to and in parallel with the sixth semiconductor layer, and is electrically insulated from the sixth semiconductor layer by the first insulating film;
a first electrode which is electrically connected to the fourth semiconductor layer, the fifth semiconductor layer, and the first conducting layer;
a second electrode which is electrically connected to one side of the first semiconductor layer opposite to the second semiconductor layer; and
a third electrode which is electrically connected to the insulated gate.

2. The semiconductor device according to claim 1, wherein the first conducting layer comprises a polycrystalline silicon.

3. The semiconductor device according to claim 2, wherein the first insulating film is thicker than the second insulating film.

4. The semiconductor device according to any one of claims 1-3, wherein a thickness of the first insulating film is equal to or more than 300 nm.

5. The semiconductor device according to claim 2, wherein the first conducting layer extends between the sixth semiconductor layer and the insulated gate.

6. The semiconductor device according to any one of claims 1-5, wherein the sixth semiconductor layer is deeper than the fourth semiconductor layer.

7. The semiconductor device according to any one of claims 1-6, wherein the sixth semiconductor layer is connected to the first electrode via a resistor means.

8. The semiconductor device according to claim 7, wherein the resistor means is made of the sixth semiconductor layer.

9. The semiconductor device according to any one of claims 1-8, wherein a seventh semiconductor layer of the second conductivity type is provided between the third semiconductor layer and the fourth semiconductor layer.

10. The semiconductor device according to claim 9, wherein a eighth semiconductor layer of the first conductivity type is provided between the third semiconductor layer and the seventh semiconductor layer.

11. A semiconductor device, comprising:
a semiconductor substrate;
a first semiconductor layer of a first conductivity type provided on a front side of the semiconductor substrate;
a second semiconductor layer of a second conductivity type which is adjacent to the first semiconductor layer in vertical and horizontal directions;
a third semiconductor layer of the second conductivity type which is adjacent to the second semiconductor layer in vertical and horizontal directions and has a carrier density which is lower than that of the second semiconductor layer, wherein
the third semiconductor layer is provided with a plurality of insulated gates which is disposed so that gaps therebetween are at least wide and narrow,
a second insulating film is provided around the insulated gate,
the fourth semiconductor layer of first conductivity type and the fifth semiconductor layer of second conductivity type are provided between the insulated gates which are disposed with the narrow gap are provided so that one side of the fourth semiconductor layer is adjacent to the third semiconductor layer and other side of the fourth semiconductor layer is adjacent to the fifth semiconductor layer,
a sixth semiconductor layer of first conductivity type is provided between the insulated gates which are disposed with the wide gap so as to be separated from the insulated gate via a part of the third semiconductor layer, and further comprising:
a first conducting layer which is provided corresponding to and in parallel with the sixth semiconductor layer, and is electrically insulated from the sixth semiconductor layer by the first insulating film;
a first electrode which is electrically connected to the fourth semiconductor layer, the fifth semiconductor layer, and the first conducting layer;
a second electrode which is electrically connected to the first semiconductor layer; and
a third electrode which is electrically connected to the insulated gate.

12. A power conversion device including the semiconductor device according to any one of claims 1-11, for converting a direct-current power to an alternating-current power.
